Europäisches Patentamt

European Patent Office

Office européen des brevets

(19)

(11) Numéro de publication : **0 010 039**
**B1**

(12) # FASCICULE DE BREVET EUROPÉEN

(45) Date de publication du fascicule du brevet :
**30.03.83**

(51) Int. Cl.³ : **H 03 H 15/02, G 11 C 19/28**

(21) Numéro de dépôt : **79400693.2**

(22) Date de dépôt : **28.09.79**

(54) **Dispositif de filtrage à transfert de charges électriques.**

(30) Priorité : **05.10.78 FR 7828518**

(43) Date de publication de la demande :
**16.04.80 Bulletin 80/08**

(45) Mention de la délivrance du brevet :
**30.03.83 Bulletin 83/13**

(84) Etats contractants désignés :
**DE GB NL**

(56) Documents cités :
**FR A 2 302 636**
**US A 3 740 591**

(73) Titulaire : **THOMSON-CSF**
**173, Boulevard Haussmann**
**F-75379 Paris Cedex 08 (FR)**

(72) Inventeur : **Auzet, Christian**
**" THOMSON-CSF "-SCPI 173, Bl. Haussmann**
**F-75360 Paris Cedex 08 (FR)**
Inventeur : **Picquendar, Jean-Edgar**
**"THOMSON-CSF "-SCPI 173, Bl. Haussmann**
**F-75360 Paris Cedex 08 (FR)**

(74) Mandataire : **Mayeux, Michèle et al**
**THOMSON-CSF SCPI 173, Bld Haussmann**
**F-75379 Paris Cedex 08 (FR)**

Jouve, 18, rue St-Denis, 75001 Paris, France

# 0 010 039

Dispositif de filtrage à transfert de charges électriques

La présente invention est relative à un dispositif de filtrage, utilisant le transfert de charges électriques dans un semi-conducteur et comportant deux filtres à transfert de charges électriques, l'un récursif et l'autre non récursif.

On rappelle qu'un filtre à transfert de charges électriques comporte généralement :

— un registre à décalages à transfert de charges électriques, réalisé sur un substrat semi-conducteur, recouvert d'une couche isolante sur laquelle sont disposées des électrodes de transfert, disposées parallèlement les unes aux autres et transversalement par rapport à la direction des charges. Ces électrodes assurent sur application périodique de potentiels donnés le transfert dans le substrat, d'un étage du registre au suivant, de paquets de charges correspondant à des échantillons du signal d'entrée à filtrer ;

— des moyens de pondération reliés à la sortie des étages du registre à décalages qui affectent d'un coefficient de pondération la quantité de charges ayant parcouru chaque étage.

Les quantités de charges pondérées sont généralement lues différentiellement et ce signal différentiel constitue le signal électrique de sortie du dispositif.

Dans un filtre récursif, ce signal est injecté à nouveau, après avoir été généralement déphasé de 180°, à l'entrée du filtre. Dans un filtre non récursif, il n'y a pas ré-injection du signal de sortie à l'entrée du filtre.

Pour réaliser un filtrage donné, il faut :

— dans le cas d'un filtrage non récursif, un grand nombre de coefficient de pondération et donc d'étages du registre à décalages,

— dans le cas d'un filtre récursif, une grande précision sur la valeur des coefficients de pondération, entraînant des difficultés pour la réalisation pratique.

Les dispositifs de filtrage à transfert de charges électriques hybrides, c'est-à-dire comportant deux filtres à transfert de charges électriques, l'un récursif et l'autre non récursif, présentent l'avantage de diminuer, pour réaliser un filtrage donné, le nombre des coefficients de pondération et la précision requise sur leurs valeurs.

La demanderesse connaît dans l'art antérieur des dispositifs où les deux registres à transfert de charges, appartenant aux deux filtres, sont réalisés sur le même substrat semi-conducteur où ils sont en série. La liaison entre les deux filtres se fait par transfert de charges. Des moyens, propres à chaque filtre, assurent la lecture des quantités de charges pondérées.

Le premier filtre est récursif et le signal issu de ses moyens de lecture est envoyé, après déphasage, vers des moyens pour l'injection de charges, se trouvant à l'entrée du filtre, qui reçoivent aussi des échantillons du signal électrique d'entrée.

Le deuxième filtre est non récursif et le signal issu de ses moyens de lecture constitue le signal de sortie du dispositif.

L'inconvénient des dispositifs hybrides connus est de nécessiter des moyens de lecture des quantités de charges pondérées propres à chaque filtre. Des dispositifs de lecture des charges, en courant ou en tension, sont connus dans l'art antérieur, notamment par la demande de brevet français n° 77.13857, publiée sous le n° 2.389.899 au nom de THOMSON-CSF. L'inconvénient de ces dispositifs est leur complexité et leur encombrement, bien plus importants notamment que ceux des moyens pour l'injection des charges.

La présente invention concerne un dispositif de filtrage à transfert de charges électriques comportant deux filtres à transfert de charges, chaque filtre comportant au moins un registre à décalages à transfert de charges, réalisé sur un substrat semi-conducteur et comprenant une couche isolante déposée sur le substrat et des électrodes de transfert, disposées parallèlement les unes aux autres et transversalement par rapport à la direction de transfert des charges, ces électrodes assurant sur application périodique de potentiels donnés le transfert des charges dans le substrat d'un étage du registre au suivant, chaque filtre comportant des moyens de pondération reliés à la sortie des étages de chaque registre à décalages qui affectent d'un coefficient de pondération la quantité de charges ayant parcouru chaque étage, des moyens d'évacuation des charges ayant parcouru le dernier étage des registres à décalages, des moyens fixant le signe des coefficients de pondération et des moyens de sommation algébrique des quantités de charges pondérées et de lecture des quantités de charges électriques, dispositif caractérisé en ce que :

— chaque registre est réalisé sur un substrat semi-conducteur distinct ;

— le premier filtre est non récursif et comporte, sur chaque registre, des moyens pour l'injection des charges correspondant à des échantillons du signal électrique d'entrée à filtrer ;

— le deuxième filtre est récursif et comporte, sur chaque registre, des moyens pour l'injection des charges correspondant au signal électrique de sortie du dispositif, préalablement déphasé de 180° par des moyens de déphasage ;

— les moyens de sommation algébrique des quantités de charges pondérées et de lecture des quantités de charges électriques sont communs aux deux filtres et fournissent le signal électrique de sortie S du dispositif de filtrage.

Le dispositif de filtrage hybride, selon l'invention, présente, par rapport aux dispositifs du même type

2

connus, de nombreux avantages parmi lesquels on peut citer :
— la diminution de la surface de substrat semi-conducteur nécessaire à la réalisation du dispositif, donc du coût et de l'encombrement du dispositif. Cette diminution est due à l'utilisation de moyens de lecture des quantités de charges pondérées commun aux deux filtres et à la réalisation des filtres et même de chaque registre sur un substrat semi-conducteur distinct. Le filtre non récursif et le filtre récursif correspondent au numérateur et au dénominateur de la fonction de transfert du dispositif de filtrage. Pour obtenir un filtrage donné, chaque filtre étant réalisé sur un substrat distinct, on peut aisément modifier sa structure pour l'adapter au résultat recherché pour le numérateur et le dénominateur de la fonction de transfert. La surface de substrat nécessaire est ainsi diminuée.

Dans un des modes de réalisation du dispositif l'un au moins des filtres peut comporter deux registres à décalages affectés à l'élaboration des coefficients de pondération d'un même signe. Dans ce cas, il est possible d'adapter les dimensions de chaque registre au résultat recherché ;
— la diminution du temps de propagation de groupe moyen du dispositif ;
— la diminution du bruit propre du dispositif et de sa sensibilité au bruit.

Un cas particulier du dispositif selon l'invention est celui où tous les coefficients de pondération sont positifs. Dans ce cas, l'invention conduit aux meilleures performances de filtrage au point de vue de la linéarité de transfert, du bruit rapporté par le dispositif de filtrage et de la dynamique obtenue pour un taux d'harmoniques donné.

D'autres objets, caractéristiques et résultats de l'invention ressortiront de la description suivante donnée à titre d'exemple non limitatif et illustrée par les figures annexées qui représentent :

les figures 1 et 2, respectivement, un schéma de principe d'un dispositif de filtrage à transfert de charges électriques hybride, selon l'art connu et selon l'invention ;

les figures 3 à 7 divers modes de réalisation du dispositif selon l'invention.

Sur les différentes figures, les mêmes repères désignent les mêmes éléments et pour des raisons de clarté les cotes et proportions des différents éléments n'ont pas été respectées.

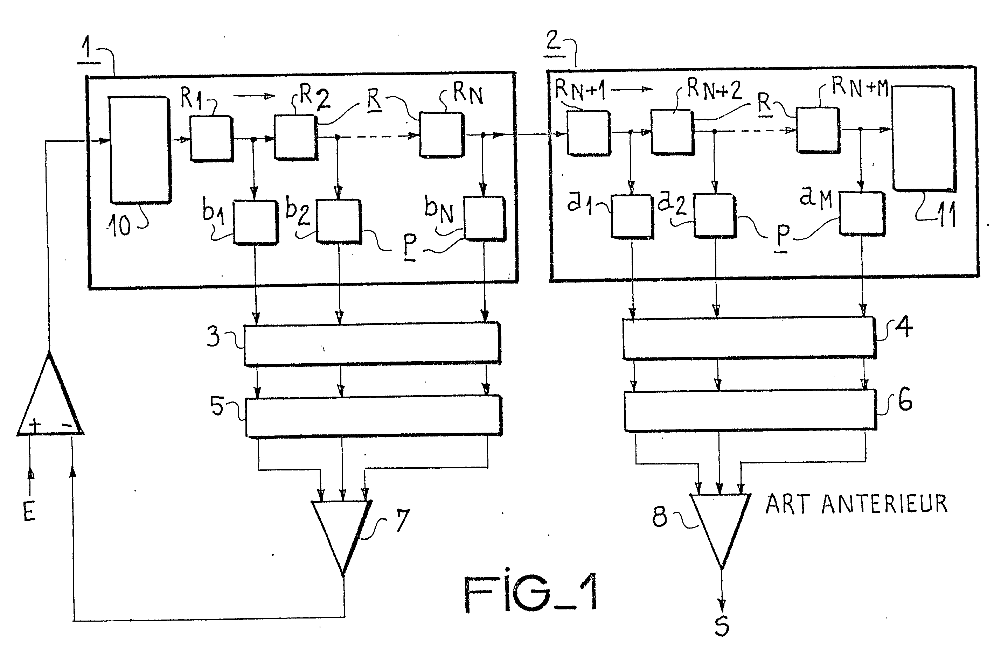

La figure 1 représente un schéma de principe d'un dispositif de filtrage à transfert de charges électriques hybride, selon l'art connu.

Sur la figure 1, où des représentations symboliques sont utilisées, le filtre récursif 1 est en série avec le filtre non récursif 2, les deux filtres étant réalisés sur un même substrat semi-conducteur. Chaque filtre comporte un registre à décalages R comportant N étages $R_1$ à $R_N$ pour le filtre récursif et M étages $R_{N+1}$ à $R_{N+M}$ pour le filtre non récursif. La liaison entre les deux filtres se fait par transfert de charges, des flèches indiquent le sens du transfert. Des moyens de pondération P sont reliés à la sortie des étapes de chaque registre et affectent d'un coefficient de pondération $b_1$ à $b_N$, pour le filtre récursif et $a_1$ à $a_M$, pour le filtre non récursif, la quantité de charges ayant parcouru chaque étape. Des moyens, propres à chaque filtre, fixent le signe des coefficients de pondération, 3 et 4, assurent la lecture des quantités de charges électriques, 5 et 6, et la sommation algébrique des quantités de charges pondérées, 7 et 8.

Le signal issu des moyens de sommation 7 du filtre récursif est envoyé, après déphasage de 180°, vers des moyens pour l'injection des charges 10, se trouvant à l'entrée du filtre, qui reçoivent aussi des échantillons du signal électrique d'entrée E, un amplificateur différentiel peut être utilisé.

Le signal issu des moyens de sommation 8 du filtre non récursif constitue le signal électrique de sortie S du dispositif. Ce filtre comporte également des moyens 11 pour l'évacuation des charges ayant parcouru l'étage $R_{N+M}$.

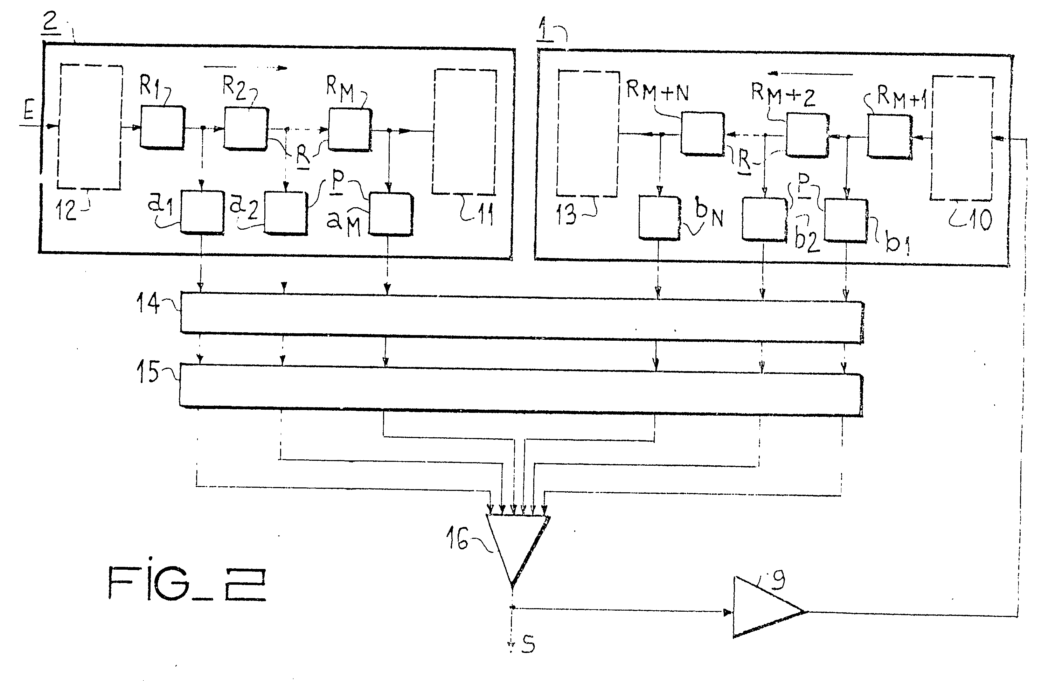

La figure 2 représente un schéma de principe du dispositif de filtrage à transfert de charges électriques hybrides selon l'invention.

Sur la figure 2, où des représentations symboliques sont utilisées, le filtre récursif 1 et le filtre non récursif 2 comportent chacun un registre à décalage R, comportant M étages de $R_1$ à $R_M$ pour le filtre non récursif et N étages de $R_{M+1}$ à $R_{M+N}$ pour le filtre récursif et réalisé sur un substrat semi-conducteur distinct. Le filtre non récursif comporte des moyens 12 pour l'injection de charges correspondant à des échantillons du signal électrique d'entrée E et le filtre récursif comporte des moyens 10 pour l'injection de charges, correspondant au signal électrique de sortie du dispositif S, préalablement déphasé de 180°, par des moyens 9. Chaque filtre comporte également des moyens 11 et 13 pour l'évacuation des charges ayant parcouru le dernier étage des registres. Des moyens 14 fixent le signe des coefficients de pondération. Enfin des moyens, communs aux deux filtres, assurent la lecture des quantités de charges électriques, 15 et la sommation algébrique des quantités de charges pondérées, 16. Ces moyens fournissent le signal électrique de sortie S du dispositif.

La transformée en z de la fonction de transfert du dispositif selon l'invention s'écrit :

$$F_1 = \frac{S(z)}{E(z)} = \frac{\sum\limits_{k=1}^{M} a_k z^k}{1 + \sum\limits_{k=1}^{N} b_k z^k}$$

0 010 039

avec $z = e^{2\pi jfT}$

f étant la fréquence du signal d'entrée E et T la période d'horloge des registres à décalages.

Si on appelle $F_2$, la transformée en z de la fonction de transfert du dispositif de la figure 1, on a :

$$F_2 = z^n \cdot F_1$$

Le dispositif de la figure 1 introduit donc, par rapport au dispositif selon l'invention, un retard constant avec la fréquence et égal à N périodes d'horloge T.

Le dispositif selon l'invention permet donc d'améliorer le temps de propagation de groupe moyen du filtre, sans modifier la courbe d'affaiblissement en fonction de la fréquence.

La fonction de transfert $F_1$ du dispositif selon l'invention peut aussi s'écrire :

$$F \qquad F_1 = G \cdot \frac{\sum\limits_{k=1}^{M} A_k z^k}{\sum\limits_{k=0}^{N} B_k z^k}$$

Les coefficients $A_k$ et $B_k$ sont normalisés pour que le gain de la fonction de transfert vaille G à une fréquence $f_0$ donnée. Les coefficients $a_k$ et $b_k$ peuvent être calculés en fonction des coefficients $A_k$ et $B_k$, de la valeur G et d'une constante $\alpha$.

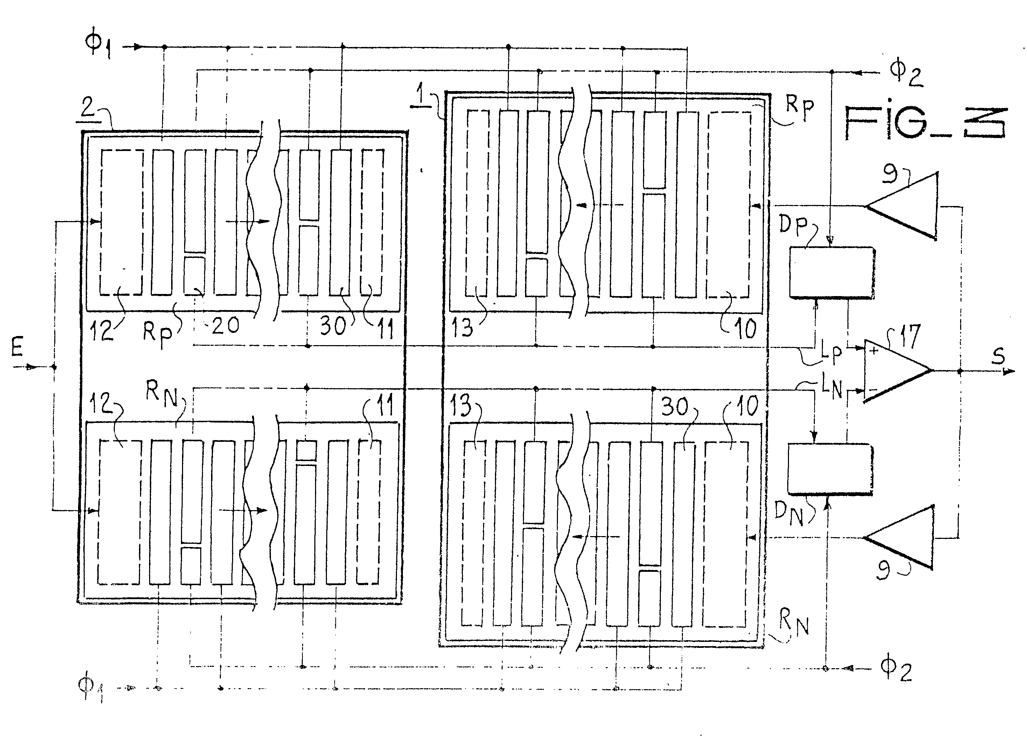

Les figures 3 à 7 représentent divers modes de réalisation du dispositif selon l'invention.

Les moyens de pondération P des quantités de charges peuvent être constitués par des ponts de résistances. Ils peuvent être aussi constitués par des électrodes de pondération, intercalés sur chaque registre avec les électrodes de transfert. Chaque électrode de pondération est divisée en au moins deux électrodes élémentaires séparées selon la direction de transfert des charges, par une coupure et une quantité de charges pondérée peut être recueillie sous chaque électrode élémentaire. Les électrodes de transfert et de pondération assurent sur application périodique de potentiels donnés le transfert des charges dans le substrat.

Sur les figures 3 à 7, les moyens de pondération sont constitués par des électrodes de pondération 20 intercalées avec des électrodes de transfert 30 recevant périodiquement un potentiel $\phi_1$ assurant le transfert des charges dans le substrat.

Sur la figure 3, chaque filtre comporte deux registres à décalages $R_P$ et $R_N$. Chaque registre est affecté à l'élaboration des coefficients de pondération d'un même signe, positif pour $R_P$, et négatif pour $R_N$.

Chaque électrode de pondération des deux registres 20 est divisée en deux électrodes élémentaires. Une quantité de charges pondérée est recueillie sous l'une des électrodes élémentaires des électrodes de pondération des deux registres par deux lignes de recueil, $L_P$ et $L_N$, recevant des quantités de charges pondérées d'un registre de chaque filtre.

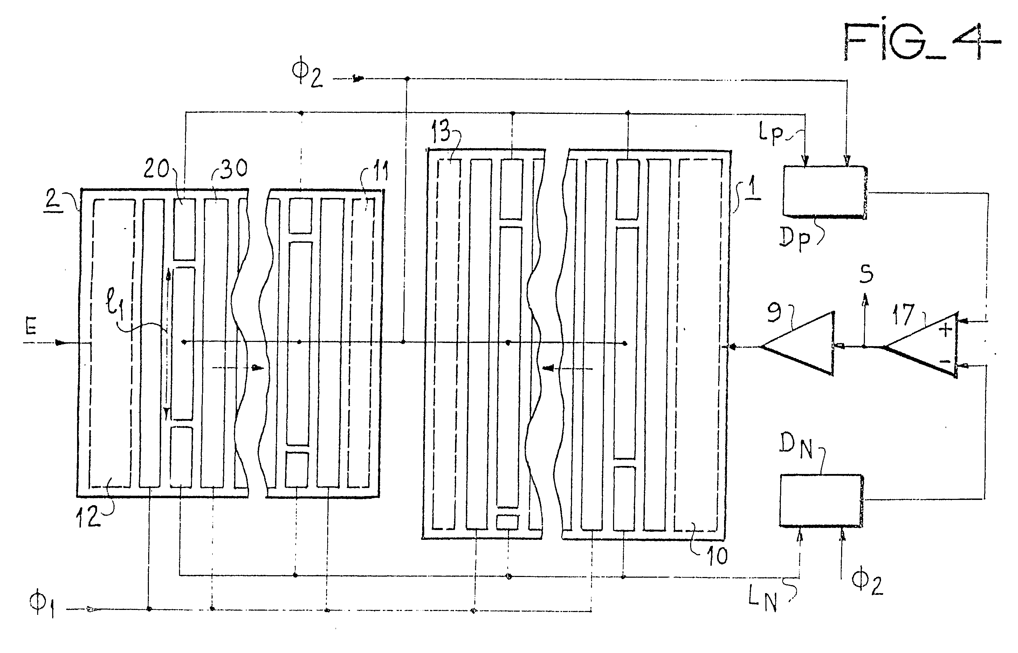

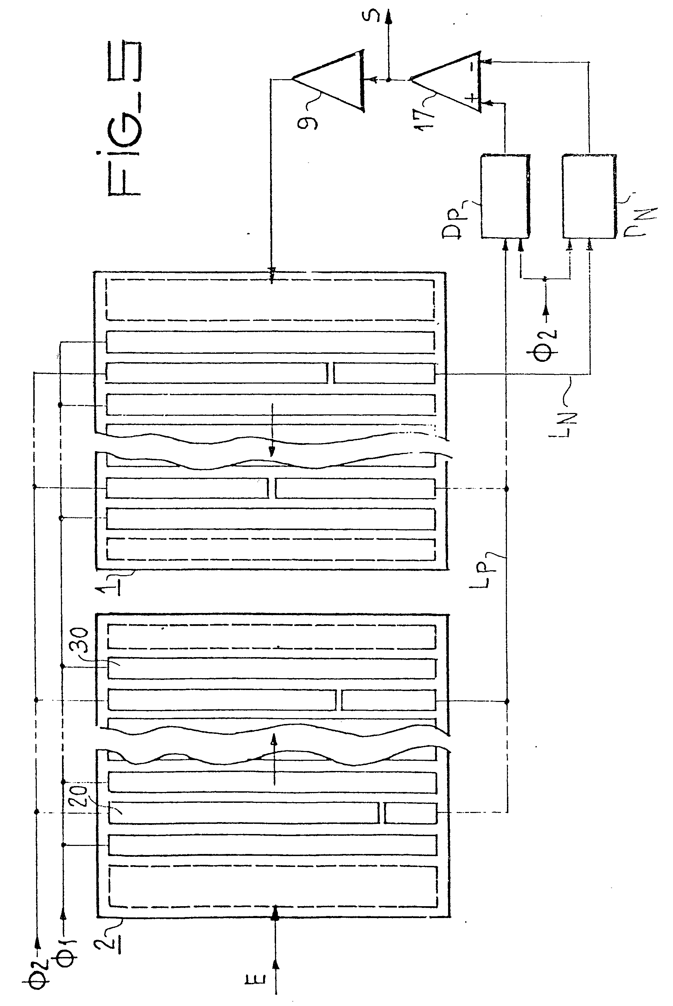

Sur la figure 3, comme sur les figures 4 et 5 décrites par la suite, les deux lignes de recueil $L_P$ et $L_N$, reçoivent de chaque filtre des quantités de charges pondérées devant être affectées d'un coefficient de pondération de même signe, ces lignes sont couplées à deux dispositifs de lecture des charges en courant ou en tension $D_P$ et $D_N$. D'autre part, pour ces trois modes de réalisation, les moyens fixant le signe des coefficients de pondération et les moyens de sommation algébrique des quantités de charges pondérées comportent un amplificateur différentiel 17 de gain unité recevant sur ses entrées les signaux issus des dispositifs de lecture.

Sur la figure 3, le dispositif $D_p$ est relié à l'entrée positive et le dispositif $D_N$ à l'entrée négative de l'amplificateur différentiel. Chaque électrode élémentaire des registres, sous laquelle des charges ne sont pas recueillies en vue de la lecture, reçoit périodiquement un potentiel donné $\phi_2$ qui assure le transfert des charges dans le substrat. Le potentiel $\phi_2$ est également appliqué aux autres électrodes élémentaires, par exemple par l'intermédiaire des dispositifs de lecture.

Sur la figure 4, chaque filtre comporte un seul registre. Chaque électrode de pondération 20 des registres est divisée en trois électrodes élémentaires. Une quantité de charge pondérées est recueillie sur deux des trois électrodes élémentaires de chaque électrode de pondération par les deux lignes de recueil $L_P$ et $L_N$. L'électrode élémentaire de chaque électrode de pondération sous laquelle des charges ne sont pas recueillies a été placée, sur la figure, entre les deux électrodes élémentaires sous lesquelles des charges sont recueillies afin de permettre une extraction plus aisée des quantités de charges pondérées. Il est bien évident que les positions respectives des trois électrodes élémentaires peuvent être modifiées.

Le mode de réalisation de la figure 4 permet, par rapport à celui de la figure 3, de réduire la surface de semi-conducteur utilisée en diminuant le nombre de registres. Cette diminution est d'autant plus importante que la largeur $l_1$ de l'électrode élémentaire sous laquelle des charges ne sont pas recueillies est plus faible. On peut alors être conduit à réaliser une ligne brisée pour connecter au potentiel $\phi_2$ les électrodes élémentaires sous lesquelles des charges ne sont pas recueillies.

4

Sur la figure 5, chaque filtre comporte un seul registre à décalages. Chaque électrode de pondération 20 est divisée en deux électrodes élémentaires. Une quantité de charges pondérée est recueillie sous l'une des électrodes élémentaires par l'une ou l'autre des deux lignes de recueil, $L_P$ et $L_N$.

Le dispositif de la figure 5 ne peut être utilisé que sous certaines conditions. En effet, pour que le transfert des charges ne soit pas perturbé par les « effets de bords », la dimension d'une électrode élémentaire, dans la direction perpendiculaire à celle du transfert des charges ou largeur, ne doit pas être inférieure à une valeur limite d. Dans les dispositifs des figures 3 et 4, où un même nombre de coefficients de chaque signe est élaboré (certains d'entre eux pouvant être nuls) on peut donner à chaque électrode élémentaire une largeur d + x, la valeur x variant en fonction du coefficient de pondération à réaliser. Dans le dispositif de la figure 5, où le nombre de coefficients de chaque signe varie avec la fonction de transfert à réaliser, cela n'est plus possible.

Le mode de réalisation de la figure 5 ne peut donc être utilisé que :
— si les « effets de bords » sont négligés ou
— si les coefficients de pondération ont des valeurs suffisamment importantes ; on doit avoir :

$$\left\{ \begin{array}{l} \text{Min} \mid B_k \mid \geqslant d/1 B_0 \\ k = 1 \dots\dots N \\ \\ G.\text{Min} \mid A_k \mid \geqslant d/1 \; B_0 \\ k = 1 \dots\dots M \end{array} \right. \tag{1}$$

où l représente la somme des largeurs des électrodes élémentaires sous lesquelles des charges sont recueillies, pour un gain donné de l'ensemble du dispositif de filtrage. Les termes $A_k$, $B_k$, G et $B_0$ (valeur du coefficient $B_k$ pour k = 0) ont été définis précédemment lors de la description de la figure 2.

Ce mode de réalisation permet de diminuer les capacités parasites rapportées par les électrodes élémentaires sur les dispositifs de lecture de charges.

Sur les figures 3 à 5, les lignes de recueils, $L_p$ et $L_N$, peuvent aussi recevoir de chaque filtre des quantités de charges pondérées devant être affectées de coefficients de pondération de signe différent, de même signe que l'entrée de l'amplificateur différentiel reliée au dispositif de lecture couplé à la ligne, pour le filtre récursif et de signe opposé pour le filtre non récursif.

Ce mode de réalisation présente l'avantage de réduire le nombre d'inverseurs nécessaires pour le bouclage du filtre récursif et permet surtout, dans certains cas, de répartir les capacités parasites rapportées sur les dispositifs de lecture par les électrodes élémentaires lorsqu'il y a déséquilibre entre les valeurs des coefficients de pondération positifs et négatifs.

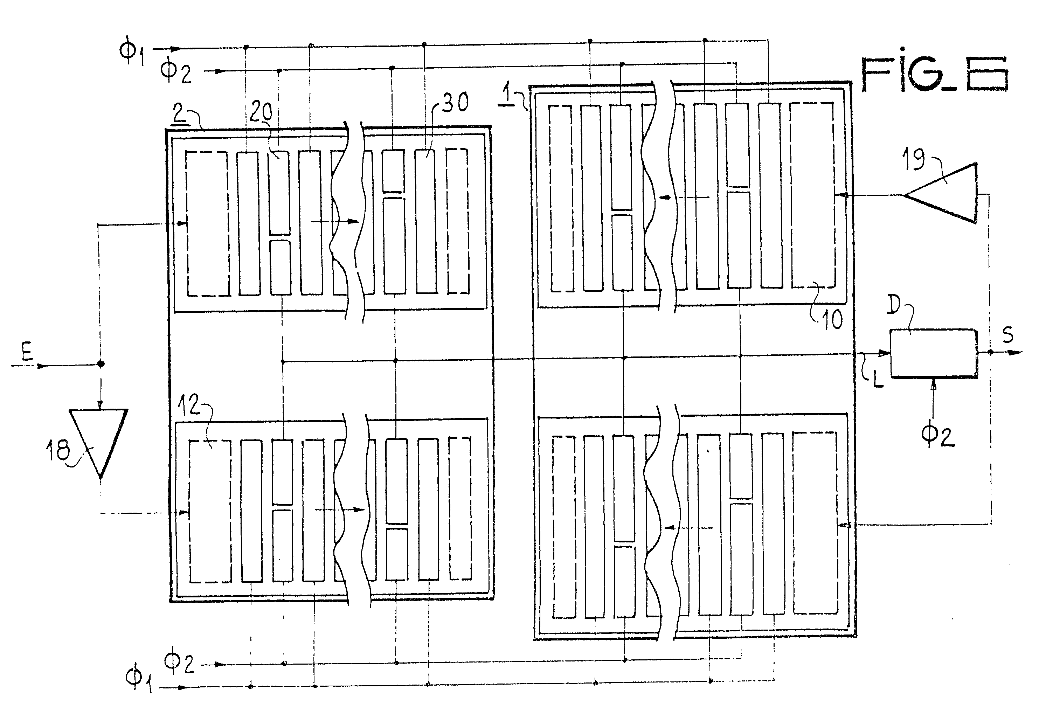

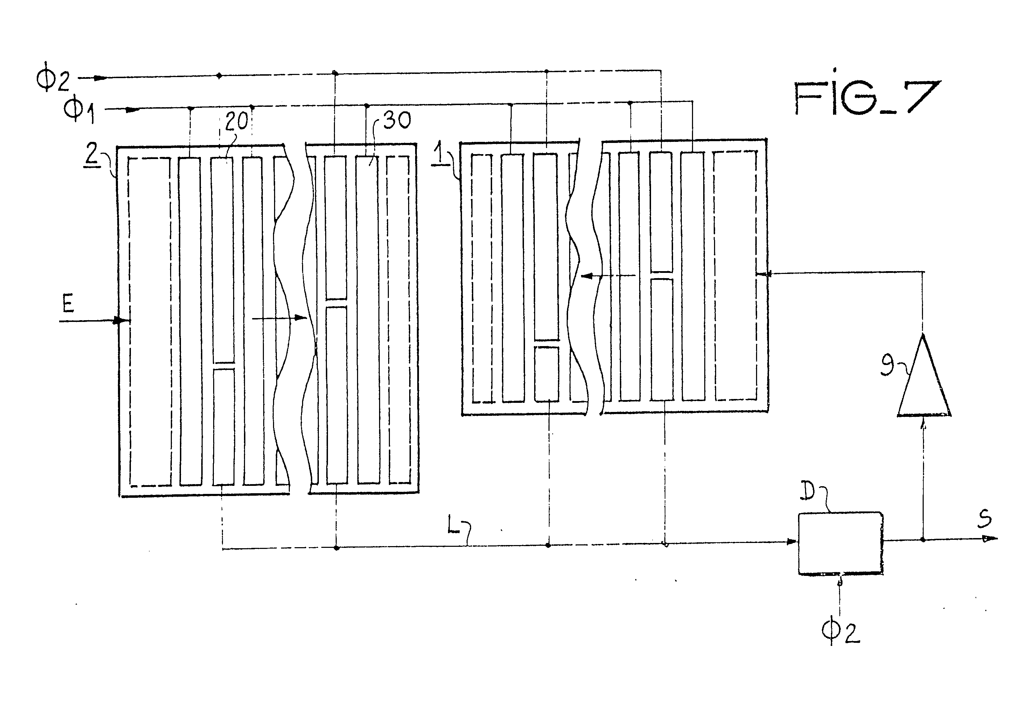

Les figures 6 et 7 représentent deux autres modes de réalisation du dispositif selon l'invention dans lesquels les moyens de sommation algébrique des quantités de charges pondérées sont constitués par une seule ligne de recueil L, recevant les charges pondérées des deux filtres.

Sur la figure 6, chaque filtre comporte deux registres $R_P$ et $R_N$. Chaque électrode de pondération 20 est divisée en deux électrodes élémentaires. Une quantité de charges pondérée est recueillie sous l'une des électrodes élémentaires de chaque électrode de pondération par la ligne de recueil L. Les moyens fixant le signe des coefficients de pondération sont constitués par deux inverseurs 18 et 19. L'inverseur 18 inverse les échantillons du signal électrique d'entrée E à filtrer avant qu'ils ne soient appliqués aux moyens pour l'injection des charges 12 du registre $R_N$, ainsi affecté à l'élaboration des coefficients de pondération négatifs, du filtre non récursif 2.

L'inverseur 19 inverse le signal électrique de sortie S avant qu'il ne soit appliqué aux moyens pour l'injection des charges 10 du registre $R_P$, ainsi affecté à l'élaboration des coefficients de pondération positifs, du filtre récursif. Les moyens de lecture sont constitués par un dispositif de lecture de charges D, couplé à la ligne de recueil L et fournissant le signal de sortie S du dispositif.

Sur la figure 7, chaque filtre comporte un seul registre. Chaque électrode de pondération 20 est divisée en deux électrodes élémentaires. Une quantité de charges pondérée est recueillie sous l'une des électrodes élémentaires de chaque électrode de pondération par la ligne de recueil L. Les moyens de lecture des quantités de charge électriques et les moyens fixant le signe des coefficients de pondération sont constitués par un dispositif de lecture des charges D, à entrée unique et ne déphasant pas, couplé à la ligne de recueil et fournissant le signal électrique de sortie S du dispositif.

Sur la figure 7, comme sur la figure 6, chaque électrode élémentaire sous laquelle des charges ne sont pas recueillies, en vue de la lecture, reçoit périodiquement un potentiel donnée $\phi_2$ qui assure le transfert des charges dans le substrat. Ce potentiel $\phi_2$ est également appliqué aux autres électrodes élémentaires, par exemple par l'intermédiaire du dispositif de lecture.

Sur la figure 7, les deux filtres ont tous leurs coefficients de pondération positifs. Ce mode de réalisation est particulièrement simple et conduit aux meilleures performances de filtrage au point de vue de la linéarité de transfert, du bruit rapporté par le dispositif et de la dynamique obtenue pour un taux d'harmoniques donné. Un autre avantage du mode de réalisation de la figure 7 est, comme celui de la figure 6, de ne pas comporter d'amplificateur différentiel, toujours difficile à intégrer. Comme le mode de réalisation de la figure 5, le mode de réalisation de la figure 7 ne peut être utilisé que :
— si les « effets de bords » sont négligés ou

— si les coefficients de pondération ont des valeurs suffisamment importantes. La relation (1) doit être vérifiée.

Pour chacun des modes de réalisation représentés sur les figures, les deux filtres 1 et 2 du dispositif de filtrage ont la même structure. Il est cependant bien entendu que l'invention concerne les dispositifs de filtrage dont l'un au moins des filtres a la structure des filtres représentés sur les figures 3 à 5. L'invention concerne aussi les dispositifs dont l'un des filtres est à coefficients de pondération positifs et a une structure analogue à celle des filtres de la figure 7 et dont l'autre filtre permet l'élaboration de coefficients positifs et négatifs et nécessite deux lignes de recueil $L_p$ et $L_N$, deux dispositifs de lecture $D_p$ et $D_N$ et un amplificateur différentiel 17 ; la ligne de recueil du filtre à coefficients positifs est alors couplée au dispositif de lecture relié à l'entrée positive de l'amplificateur différentiel.

Tout dispositif qui diffère de ceux exposés par le nombre de phases des registres à décalages, le nombre et la place des moyens 9 déphasant de 180°, qui peuvent être modifiés sans changer le résultat, ne sort pas du cadre de l'invention.

Le dispositif selon l'invention peut être précédé par un dispositif de pré-filtrage qui permet de sélectionner la bande de fréquence contenant la fonction de transfert recherchée, car le dispositif selon l'invention a une réponse périodique en fréquence. Des dispositifs de pré-filtrage sont connus, par exemple par l'article « Antialiasing inputs for charge couplet devices » de Carlo H. Seguin, paru dans la revue américaine « IEEE Journal of Solid-State Circuits », volume SC 12, numéro 6, décembre 1977, pages 609 à 616. Ce dispositif peut être placé, si on considère la figure 2, entre le dispositif d'injection de charges 12 du filtre non récursif 2 et le premier étage $R_1$ du registre à décalages.

## Revendications

1. Dispositif de filtrage à transfert de charges électriques comportant deux filtres à transfert de charges (1, 2), chaque filtre comportant au moins un registre à décalages à transfert de charges (R), réalisé sur un substrat semi-conducteur et comprenant une couche isolante déposée sur le substrat et des électrodes de transfert (30), disposées parallèlement les unes aux autres et transversalement par rapport à la direction de transfert des charges, ces électrodes assurant sur application périodique de potentiels donnés le transfert des charges dans le substrat d'un étage du registre au suivant, chaque filtre comportant des moyens de pondération (P) reliés à la sortie des étages de chaque registre à décalages qui affectent d'un coefficient de pondération la quantité de charges ayant parcouru chaque étage, des moyens (11, 13) d'évacuation des charges ayant parcouru le dernier étage des registres à décalages, des moyens fixant le signe des coefficients de pondération (14) et des moyens de sommation algébrique des quantités de charges pondérées (16) et de lecture des quantités de charges électriques (15), dispositif caractérisé en ce que :

— chaque registre est réalisé sur un substrat semi-conducteur distinct ;

— le premier filtre est non récursif (2) et comporte, sur chaque registre, des moyens pour l'injection des charges (12) correspondant à des échantillons du signal électrique d'entrée à filtrer (E) ;

— le deuxième filtre est récursif (1) et comporte, sur chaque registre, des moyens pour l'injection des charges (10) correspondant au signal électrique de sortie (S) du dispositif, préalablement déphasé de 180° par des moyens de déphasage (9) ;

— les moyens de sommation algébrique des quantités de charges pondérées (16) et de lecture des quantités de charges électriques (15) sont communs aux deux filtres et fournissent le signal électrique de sortie S du dispositif de filtrage.

2. Dispositif selon la revendication 1, caractérisé en ce que les moyens de pondération (P) sont constitués par des électrodes de pondération (20), intercalées sur chaque registre, avec les électrodes de transfert (30), chaque électrode de pondération étant divisée en au moins deux électrodes élémentaires séparées, selon la direction de transfert des charges, par une coupure, une quantité de charges pondérée pouvant être recueillie sous chaque électrode élémentaire, les électrodes de transfert et de pondération assurant sur application périodique de potentiels donnés ($\phi_1$, $\phi_2$) le transfert des charges dans le substrat.

3. Dispositif selon la revendication 1, caractérisé en ce que les moyens de lecture sont constitués par deux dispositifs de lecture de charges en courant ou en tension ($D_P$, $D_N$), couplés à deux lignes de recueil des quantités de charges pondérées des deux filtres ($L_P$, $L_N$) et en ce que les moyens fixant le signe des coefficients de pondération et les moyens de sommation algébrique des quantités de charges pondérées comportent un amplificateur différentiel (17) de gain unité recevant les signaux issus des dispositifs de lecture de charges.

4. Dispositif selon la revendication 3, caractérisé en ce que les deux lignes de recueil ($L_P$, $L_N$) reçoivent de chaque filtre (1, 2) des quantités de charges pondérées devant être affectées d'un coefficient de pondération de même signe par les moyens fixant le signe.

5. Dispositif selon la revendication 3, caractérisé en ce que les deux lignes de recueil ($L_P$, $L_N$) reçoivent de chaque filtre (1, 2) des quantités de charges pondérées devant être affectées de coefficients de pondération de signe différent, de même signe que l'entrée de l'amplificateur différentiel (17) reliée au dispositif de lecture couplé à la ligne de recueil, pour le filtre récursif (1) et de signe opposé, pour le filtre non récursif (2).

6. Dispositif selon la revendication 2, et selon l'une des revendications 4 et 5, caractérisé en ce que l'un au moins des deux filtres (1, 2) du dispositif comporte deux registres à décalages à transfert de charges ($R_P$, $R_N$) et en ce que chaque électrode de pondération (20), des deux registres, étant divisée en deux électrodes élémentaires, une quantité de charges pondérée est recueillie sous l'une des électrodes élémentaires des électrodes de pondération des deux registres par les deux lignes de recueil ($L_P$, $L_N$), chaque ligne recevant des quantités de charges pondérées d'un registre.

7. Dispositif selon la revendication 2, et selon l'une des revendications 4 et 5, caractérisé en ce que l'un au moins des deux filtres du dispositif (1, 2) comporte un seul registre à décalages à transfert de charges et en ce que chaque électrode de pondération du registre (20) étant divisée en trois électrodes élémentaires, une quantité de charges pondérée est recueillie sous deux des trois électrodes élémentaires de chaque électrode de pondération du registre par les deux lignes de recueil ($L_P$, $L_N$).

8. Dispositif selon la revendication 2, et selon l'une des revendications 4 et 5, caractérisé en ce que l'un au moins des deux filtres du dispositif (1, 2) comporte un seul registre à décalages à transfert de charges et en ce que chaque électrode de pondération du registre (20) étant divisée en deux électrodes élémentaires, une quantité de charges pondérée est recueillie sous l'une des électrodes élémentaires de chaque électrode de pondération par l'une ou l'autre des deux lignes de recueil ($L_P$, $L_N$).

9. Dispositif selon la revendication 2, et selon l'une des revendications 4 et 5, caractérisée en ce que l'un des filtres (1, 2), à coefficients de pondération positifs comporte un seul registre à décalages à transfert de charges et en ce que chaque électrode de pondération (20) étant divisée en deux électrodes élémentaires, une quantité de charges pondérée est recueillie sous l'une des électrodes élémentaires de chaque électrode de pondération par la même ligne de recueil, couplée au dispositif de lecture de charges relié à l'entrée positive de l'amplificateur différentiel (17), l'autre filtre du dispositif permettant l'élaboration de coefficients de pondération positifs et négatifs et utilisant les deux lignes de recueil des charges ($L_P$, $L_N$), les deux dispositifs de lecture de charge ($D_P$, $D_N$) et les deux entrées de l'amplificateur différentiel (17).

10. Dispositif selon la revendication 1, caractérisé en ce que les moyens de sommation algébrique des quantités de charges pondérées sont constitués par une ligne de recueil (L) des charges pondérées des deux filtres (1, 2).

11. Dispositif selon la revendication 10, caractérisé en ce que les deux filtres (1, 2) comportent deux registres à décalages à transfert de charges et en ce que chaque électrode de pondération (20) des registres étant divisée en deux électrodes élémentaires une quantité de charges pondérée est recueillie sous l'une des électrodes élémentaires de chaque électrode de pondération des registres par la ligne de recueil (L), les moyens fixant le signe des coefficients de pondération étant constitués par deux inverseurs (18, 19) inversant d'une part les échantillons du signal électrique d'entrée E à filtrer avant qu'ils ne soient appliqués aux moyens pour l'injection de charges (12) d'un des registres à décalages ($R_N$), ainsi affecté à l'élaboration des coefficients de pondération négatifs, du filtre non récursif (2) et inversant d'autre part le signal électrique de sortie S avant qu'il ne soit appliqué aux moyens pour l'injection de charges (10) d'un des registres à décalages ($R_P$), ainsi affecté à l'élaboration des coefficients de pondération positifs, du filtre récursif (1), les moyens de lecture des quantités de charges électriques étant constitué par un dispositif de lecture des charges en courant ou en tension (D), couplé à la ligne de recueil et fournissant le signal électrique de sortie du dispositif.

12. Dispositif selon la revendication 10, caractérisé en ce que les deux filtres (1, 2), à coefficients de pondération positifs, comportent un seul registre à décalages à transfert de charges et en ce que chaque électrode de pondération (20) étant divisée en deux électrodes élémentaires, une quantité de charges pondérée est recueillie sous l'une des électrodes élémentaires de chaque électrode de pondération par la ligne de recueil (L), les moyens de lecture des quantités de charges électriques et les moyens fixant le signe des coefficients de pondération étant constitués par un dispositif de lecture des charges, en courant ou en tension (D), à entrée unique et ne déphasant pas, couplé à la ligne de recueil et fournissant le signal électrique de sortie du dispositif S.

## Claims

1. Electric charge transfer filtering device comprising two charge transfer filters (1, 2), each filter comprising at least one charge transfer shift register (R) formed on a semiconductor substrate and comprising an insulating layer deposited on the substrate and transfer electrodes (30) arranged in parallel to each other and transversely with respect to the charge transfer direction, these electrodes providing for the charge transfer within the substrate from one stage of the register to the following upon periodic application of determined potentials, each filter comprising weighting means (P) connected to the output of the stages of each shift register affecting the charge quantity having passed through each stage by a weighting coefficient, charge elimination means (11, 13) for elimination of the charges having passed through the last stage of the shift registers, means for determination of the sign of the weighting coefficients (14) and means for algebraic summing of the weighted charge quantities (16) and for reading of the electric charge quantities (15), the device being characterized in that :

— each register is formed on a different semiconductor substrate ;

— the first filter is non-recursive (2) and comprises, on each register, means for the injection of charges (12) corresponding to samples of the electric input signal (E) to be filtered ;

— the second filter (1) is recursive and comprises, on each register, means for the injection of charges (10) corresponding to the electric output signal (S) of the device, previously 180° phase-shifted by phase-shifting means (9) ;

— the means for algebraic summing of the weighted charge quantities (16) and for reading the electric charge quantities (15) are common to both filters and provide the electric output signal (S) of the filtering device.

2. Device in accordance with claim 1, characterized in that the weighting means (P) are formed by weighting electrodes (20) interlaced on each register with the transfer electrodes (30), each weighting electrode being divided into at least two elementary electrodes separated from each other by a cut along the charge transfer direction, a weighted charge quantity being adapted to be collected under each elementary electrode, the transfer and weighting electrodes assuring the charge transfer within the substrate upon periodic application of determined potentials ($\phi_1$, $\phi_2$).

3. Device in accordance with claim 1, characterized in that the reading means are formed by two current or voltage charge reading devices ($D_P$, $D_N$) coupled to two weighted charge quantities collection lines of the two filters ($L_P$, $L_N$), and in that the means for determination of the sign of the weighting coefficients and the means for algebraic summing of the weighted charge quantities comprise a differential amplifier (17) of unity gain receiving the signals issued from the charge reading devices.

4. Device in accordance with claim 3, characterized in that the two collection lines ($L_P$, $L_N$) receive from each filter (1, 2) weighted charge quantities which have to be affected by a weighting coefficient of the same sign by the sign determination means.

5. Device in accordance with claim 3, characterized in that the two collection lines ($L_P$, $L_N$) receive from each filter (1, 2) weighted charge quantities which have to be affected by weighting coefficients of different signs, of the same sign as that of the input of the differential amplifier (17) connected to the reading device coupled to the collection line, with respect to the recursive filter (1), and of opposite sign with respect to the non-recursive filter (2).

6. Device in accordance with claim 2 and any of claims 4 and 5, characterized in that at least one of the filters (1, 2) of the device comprises two charge transfer shift registers ($R_P$, $R_N$) and in that each weighting electrode (20) of both registers is divided into two elementary electrodes, a weighted charge quantity being collected under one of the elementary electrodes of the weighting electrodes of both registers by the two collection lines ($L_P$, $L_N$), each line receiving the weighted charge quantities of one register.

7. Device in accordance with claim 2 and any of claims 4 and 5, characterized in that at least one of the two filters (1, 2) of the device comprises a single charge transfer shift register and in that each weighting electrode (20) of the register is divided into three elementary electrodes, a weighted charge quantity being collected under two of the three elementary electrodes of each weighting electrode of the register by the two collection lines ($L_P$, $L_N$).

8. Device in accordance with claim 2 and any of claims 4 and 5, characterized in that at least one of the two filters (1, 2) of the device comprises a single charge transfer shift register and in that each weighting electrode (20) of the register is divided into two elementary electrodes, a weighted charge quantity being collected under one of the elementary electrodes of each weighting electrode by one or the other of two collection lines ($L_P$, $L_N$).

9. Device in accordance with claim 2 and any of claims 4 and 5, characterized in that one of the filters (1, 2), which have positive weighting coefficients, comprises a single charge transfer shift register, and in that each weighting electrode (20) is divided into two elementary electrodes, a weighted charge quantity being collected under one of the elementary electrodes of each weighting electrode by the same collection line coupled to the charge reading device connected to the positive input of the differential amplifier (17), the other filter of the device permitting the generation of the positive and negative weighting coefficients and using the two charge collection lines ($L_P$, $L_N$), the two charge reading devices ($D_P$, $D_N$) and the two inputs of the differential amplifier (17).

10. Device in accordance with claim 1, characterized in that the means for algebraic summing of the weighted charge quantities are formed by a collection line (L) for collecting the weighted charges of both filters (1, 2).

11. Device in accordance with claim 10, characterized in that the two filters (1, 2) comprise two charge transfer shiff registers and in that each weighting electrode (20) of the registers is divided into two elementary electrodes, a weighted charge quantity being collected under one of the elementary electrodes of each weighting electrode of the registers by a collection line (L), the weighting coefficient sign determination means being formed by two inverters (18, 19) inverting the samples of the electric input signal E to be filtered before they are applied to the charge injection means (12) of one of the shift registers ($R_N$) thus associated with the generation of negative weighting coefficients of the non-recursive filter (2), on the one hand, and inverting the electric output signal S before it is applied to the charge injection means (10) of one of the shift registers ($R_P$) thus assigned to the generation of positive weighting coefficients of the recursive filter (1), on the other hand, the electric charge quantities reading means being formed by a current or voltage charge reading divice (D) coupled to the collection line and

8

# 0 010 039

providing the electric output signal of the device.

12. Device in accordance with claim 10, characterized in that the two filters (1, 2), which have positive weighting coefficients, comprise a single charge transfer shift register and in that each weighting electrode (20) is divided into two elementary electrodes, a weighted charge quantity being collected under one of the elementary electrodes of each weighting electrode by the collection line (L), the electric charge quantity reading means and the weighting coefficient sign determination means being formed by a current or voltage charge reading device (D) having a single input and no phase-shift, coupled to the collection line and providing the electric output signal S of the device.

**Ansprüche**

1. Mit Verschiebung elektrischer Ladungen arbeitende Filtervorrichtung, die zwei Ladungsverschiebefilter (1, 2) enthält, wovon jedes Filter wenigstens ein Ladungsverschiebe-Schieberegister (R) umfaßt, das auf einem Halbleitersubstrat verwirklicht ist und eine auf dem Substrat aufgebrachte Isolierschicht sowie Verschiebeelektroden (30) umfaßt, die parallel zueinander und transversal in Bezug auf die Ladungsüberführungsrichtung angeordnet sind, wobei diese Elektroden beim periodischen Anlegen von gegebenen Potentialen die Ladungsüberführung in dem Substrat von einer Stufe des Registers zur nächsten gewährleisten, wobei jedes Filter umfaßt : Wichtungsmittel (P), die mit dem Ausgang der Stufen jedes Schieberegisters verbunden sind und die Ladungsgröße, die jede Stude durchlaufen hat, mit einem Wichtungskoeffizienten behaften, Mittel (11, 13) zur Beseitigung der Ladungen, die die letzte Stufe der Schieberegister durchlaufen haben, Mittel (14) welche das Vorzeichen der Wichtungskoeffizienten festlegen, und Mittel zum algebraischen Summieren der gewichteten Ladungsgrößen (16) und zum Auslesen der elektrischen Ladungsgrößen (15) ; wobei die Vorrichtung dadurch gekennzeichnet ist, daß :
— jedes Register auf einem verschiedenen Halbleitersubstrat verwirklicht ist ;
— das erste Filter ein nicht-rekursives (2) Filter ist und an jedem Register Mittel (12) zur Injektion von Ladungen umfaßt, die Abtastproben des zu filternden elektrischen Eingangssignals (E) entsprechen ;
— das zweite Filter ein rekursives Filter (1) ist und an jedem Register Mittel (10) zum Injizieren der Ladungen umfaßt, die dem elektrischen Ausgangssignal der Vorrichtung entsprechen, welches zuvor durch Phasenschiebermittel (9) um 180° phasenverschoben wurde ;
— die Mittel (16) zum algebraischen Summieren der gewichteten Ladungsgrößen und die Mittel (15) zum Auslesen der elektrischen Ladungsgrößen den beiden Filtern gemeinsam sind und das elektrische Ausgangssignal (S) der Filtervorrichtung abgeben.

2. Vorrichtung nach Anspruch 1, dadurch gekennzeichnet, daß die Wichtungsmittel (P) durch Wichtungselektroden (20) gebildet sind, die an jedem Register zwischen die Überführungselektroden (30) eingefügt sind, wobei jede Wichtungselektrode in wenigstens zwei Elementarelektroden unterteilt ist, die in Richtung der Ladungsüberführung durch einen Schnitt voneinander getrennt sind, wobei eine gewichtete Ladungsgröße unter jeder Elementarelektrode abgenommen werden kann und wobei die Überführungselektroden und die Wichtungselektroden beim periodischen Anlegen von gegebenen Potentialen ($\phi_1$, $\phi_2$) die Überführung der Ladungen in dem Substrat gewährleisten.

3. Vorrichtung nach Anspruch 1, dadurch gekennzeichnet, daß die Auslesemittel gebildet sind durch zwei Strom- oder Spannungs-Ladungslesevorrichtungen ($D_P$, $D_N$), die an zwei Leitungen zum Abnehmen der gewichteten Ladungsgrößen der beiden Filter ($L_P$, $L_N$) angekoppelt sind, und daß die das Vorzeichen der Wichtungskoeffizienten festlegenden Mittel sowie die Mittel zum algebraischen Summieren der gewichteten Ladungsgrößen einen Differenzverstärker (17) der Verstärkung 1 umfassen, welcher die von den Ladungslesevorrichtungen abgegebenen Signale empfängt.

4. Vorrichtung nach Anspruch 3, dadurch gekennzeichnet, daß die beiden Abnahmeleitungen ($L_P$, $L_N$) aus jedem Filter (1, 2) gewichtete Ladungsgrößen empfangen, die durch die Vorzeichen-Festlegungsmittel mit einem Wichtungskoeffizienten des selben Vorzeichens behaftet werden sollen.

5. Vorrichtung nach Anspruch 3, dadurch gekennzeichnet, daß die beiden Abnahmeleitungen ($L_P$, $L_N$) aus jedem Filter (1, 2) gewichtete Ladungsgrößen empfagen, die mit Wichtungskoeffizienten verschiedener Vorzeichen behaftet werden sollen, mit dem selben Vorzeichen wie der Eingang des Differenzverstärkers (17), der an die an die Abnahmeleitung angekoppelte Lesevorrichtung angeschlossen ist, was das rekursive Filter (1) anbetrifft, und mit entgegengesetztem Vorzeichen, was das nicht-rekursive Filter (2) betrifft.

6. Vorrichtung nach Anspruch 2 und einem der Ansprüche 4 und 5, dadurch gekennzeichnet, daß wenigstens eines der beiden Filter (1, 2) der Vorrichtung zwei Ladungsverschiebe-Schieberegister ($R_P$, $R_N$) umfaßt und daß jede Wichtungselektrode (20) der beiden Register in zwei Elementarelektroden unterteilt ist, wobei eine gewichtete Ladungsgröße unter einer der Elementarelektroden der Wichtungselektroden der beiden Register durch die beiden Abnahmeleitungen ($L_P$, $L_N$) abgenommen wird und wobei jede Leitung gewichtete Ladungsgrößen eines Registers abnimmt.

7. Vorrichtung nach Anspruch 2 und einem der Ansprüche 4 und 5, dadurch gekennzeichnet, daß wenigstens eines der beiden Filter (1, 2) der Vorrichtung ein einziges Ladungsverschiebe-Schieberegister umfaßt und daß jede Wichtungselektrode (20) des Registers in drei Elementarelektroden unterteilt ist, wobei eine gewichtete Ladungsgröße unter zwei der drei Elementarelektroden jeder Wichtungselektrode des Registers durch die beiden Abnahmeleitungen ($L_P$, $L_N$) abgenommen wird.

9

8. Vorrichtung nach Anspruch 2 und einem der Ansprüche 4 und 5, dadurch gekennzeichnet, daß wenigstens eines der beiden Filter (1, 2) der Vorrichtung ein einziges Ladungsverschiebe-Schieberegister umfaßt und daß jede Wichtungselektrode (20) des Registers in zwei Elementarelektroden unterteilt ist, wobei eine gewichtete Ladungsgröße unter einer der Elementarelektroden jeder Wichtungselektrode durch die eine oder andere der beiden Abnahmeleitungen ($L_P$, $L_N$) abgenommen wird.

9. Vorrichtung nach Anspruch 2 und einem der Ansprüche 4 und 5, dadurch gekennzeichnet, daß eines der beiden Filter (1, 2) mit positivem Wichtungskoeffizienten ein einziges Ladungsverschiebe-Schieberegister umfaßt und daß jede Wichtungselektrode (20) in zwei Elementarelektroden unterteilt ist, wobei eine gewichtete Ladungsgröße unter einer der Elementarelektroden jeder Wichtungselektrode durch die selbe Abnahmeleitung abgenommen wird, welche mit der Ladungslesevorrichtung verbunden ist, die an den positiven Eingang des Differenzverstärkers (17) angeschlosen ist, wobei das andere Filter der Vorrichtung die Erzeugung von positiven und negativen Wichtungskoeffizienten ermöglicht und von den beiden Ladungsabnahmeleitungen ($L_P$, $L_N$), den beiden Ladungslesevorrichtungen ($D_P$, $D_N$) und den beiden Eingängen des Differenzverstärkers (17) Gebrauch macht.

10. Vorrichtung nach Anspruch 1, dadurch gekennzeichnet, daß die Mittel zum algebraischen Summieren der gewichteten Ladungsgrößen durch eine Abnahmeleitung (L) zum Abnehmen der gewichteten Ladungen der beiden Filter (1, 2) gebildet sind.

11. Vorrichtung nach Anspruch 10, dadurch gekennzeichnet, daß die beiden Filter (1, 2) zwei Ladungsverschiebe-Schieberegister umfassen und daß jede Wichtungselektrode (20) der Register in zwei Elementarelektroden unterteilt ist, wobei eine gewichtete Ladungsgröße unter einer der Elementarelektroden jeder Wichtungselektrode der Register durch eine Abnahmeleitung (L) abgenommen wird, wobei ferner die das Vorzeichen der Wichtungskoeffizienten festlegenden Mittel gebildet sind durch zwei Inverter (18, 19), welche zum einen die Abtastproben des elektrischen Eingangssignals (E), das gefiltert werden soll, invertieren, bevor sie an die Ladungsinjiziermittel (12) eines der Schieberegister ($R_N$) angelegt werden, welches auf diese Weise der Erzeugung von negativen Wichtungskoeffizienten des nicht-rekursiven Filters (2) zugeordnet ist, und zum anderen das elektrische Ausgangssignal S invertieren, bevor es an die Ladungsinjiziermittel (10) eines der Schieberegister ($R_P$) angelegt wird, das auf diese Weise der Erzeugung von positiven Wichtungskoeffizienten des rekursiven Filters (1) zugeordnet ist, und wobei die Mittel zum Auslesen der elektrischen Ladungsgrößen durch eine Strom- oder Spannungs-Ladungslesevorrichtung (D) gebildet sind, die an die Abnahmeleitung angekoppelt ist und das elektrische Ausgangsignal der Vorrichtung liefert.

12. Vorrichtung nach Anspruch 10, dadurch gekennzeichnet, daß die beiden Filter (1, 2), welche positive Wichtungskoeffizienten aufweisen, ein einziges Ladungsverschiebe-Schieberegister umfassen und daß jede Wichtungselektrode (20) in zwei Elementarelektroden unterteilt ist, wobei eine gewichtete Ladungsgröbe unter einer der Elementarelektroden jeder Wichtungselektrode durch die Abnahmeleitung (L) abgenommen wird und wobei die Mittel zum Lesen der elektrischen Ladungsgrößen un die das Vorzeichen der Wichtungskoeffizienten festlegenden Mittel durch eine Strom- oder Spannungs-Ladungslesevorrichtung (D) gebildet sind, die nur einen Eingang und keine Phasenverschiebung aufweist, an die Abnahmeleitung angekoppelt ist und das elektrische Ausgangssignal S der Vorrichtung liefert.

FIG_1

ART ANTERIEUR

0 010 039

FiG_2

0 010 039

FIG_2

FIG_4

FIG_5

0 010 039

FIG_6

FIG_7